# EUROPÄISCHE PATENTANMELDUNG

(11) **EP 0 658 678 A1**
(43) Veröffentlichungstag der Anmeldung: **21.06.1995**
(21) Anmeldenummer: 93203560.3
(22) Anmeldetag: 17.12.1993
(51) Int. Cl.: E06B 5/18

(54) **Schutz-Fensterelemente**

(71) Anmelder: HERMANN FORSTER AG, CH-9320 Arbon (CH)
(72) Erfinder: Grütter, Beat, CH-9320 Arbon (CH); Sutter, Roland, CH-9320 Arbon (CH)
(74) Vertreter: Hepp, Dieter

(57) **Zusammenfassung**

Das Schutz-Fensterelement ist in einem Rahmenprofil (5) angeordnet. Ein Verbundpaket (10, 20) mit wenigstens zwei Glasscheiben (11, 12) ist mit einer Metallschicht (3, 12) versehen, die sich über die gesamte Flächenausdehnung des Glaspakets erstreckt. Am Aussenrand des Glaspakets sind Kontaktierungselemente (4, 24) vorgesehen, die mit Kontaktierungsprofilleisten (7, 34) verbindbar sind.

## Beschreibung

Die Erfindung bezieht sich auf ein Schutz-Fensterelement gemäß Oberbegriff des Anspruchs 1, wie es beispielsweise zur Abschirmung unerwünschter Außeneinflüsse Verwendung findet.

Es ist bekannt, wärme- und schalldämmende Vorkehrungen an Fensterelementen vorzusehen, die als Wärme- oder Achallschutzfenster an Gebäuden eingesetzt werden.

So wird bei Schallschutzfenstern eine Zweischeibenverglasung vorgesehen, bei denen die beiden Scheiben unterschiedliche Scheibendicke aufweisen, wobei die beiden Scheiben in einem möglichst großen Abstand zueinander angeordnet sind. Besonders gute Werte werden durch gasgefüllte Verglasungen erzielt ("Schwachstellen", Band V, Bauverlag GmbH, Wiesbaden & Berlin, Seiten 17 und 23).

Des weiteren ist bekannt, den Abschirmungseffekt durch Einbringen von transparenten Kunststoffolien an der Innenseite eines Scheibenpakets zu erhohen. Diese Folien sind dabei auf der Glasscheibe durch Aufkleben oder thermische Einwirkung so aufgebracht, daß sie als Beschichtung der Glasscheibe angesehen werden können.

Auch ist bekannt, bei Schallschutzfenstern eine Dreifachverglasung vorzusehen, bei der zwei der Glasscheiben zwischen sich eine Gießharzschicht aufweisen, also praktisch über diese miteinander verklebt sind, während im Zwischenraum zwischen den beiden verklebten Scheiben und der dritten Glasscheibe eine Gasfüllung aus einem Schwefel-Fluor-Gas vorgesehen ist.

Schließlich sind Wärme- oder Sonnenschutzfenster bekannt, die ebenfalls aus mindestens zwei Glasscheiben bestehen, deren mindestens eine Glasscheibe mit einer metallischen Beschichtung versehen ist. Die metallische Beschichtung ist relativ transparent, wobei sie unterschiedliche Farbgebungen aufweisen kann wie grün, blau, golden oder farblos. Zudem ist der Zwischenraum zwischen den Glasscheiben mit einer Gasfüllung aus Argon versehen. Diese bekannte Metallbeschichtung dient der Verhinderung von Wärmeverlusten nach außen und Verringerung von Sonneneinstrahlung nach innen.

Abgesehen von Wärme-, Sonnen- und Schalleinwirkungen, die abzuschirmen sind, gilt es in vielen Anwendungsfällen, einen Gebäuderaum gegen weitere, in diesen insbesondere über Fensterelemente eindringende Störungen abzuschirmen. Diese Störungen können durch elektrische Strahlen, magnetische Felder und/oder elektrische Wellen auftreten. So können beispielsweise durch ungehinderten Einlaß von Störstrahlungen an z. B. in Edelstahlfassaden integrierten Glasbauelementen von außen Negativauswirkungen auftreten, beispielsweise in medizinisch technischen Diagnose- und Forschungsbereichen von Spitälern, Krankenhäusern, wodurch Fehlmessungen von EEG/EMG/Ultraschall usw. bedingt werden können. Auch können durch Trennwände, Glaswände und deren Kombination ein- und ausdringende Störeinflüsse von Erzeugerquellen in Gebäudeinneren (Kernspintograph, Trafostationen, Starkstromtrassen usw.) hervorgerufen werden.

Andererseits sind als Störungen gezielte Eingriffe von außen anzusehen wie unbefugtes Abrufen (Anzapfen, elektronisches Abhören) von schutzbedürftigen Unternehmensdaten oder deren Manipulation durch ungeschirmte Gebäudefassadenelemente und Fensterflächen. Dies ist insbesondere wichtig bei behördlichen Institutionen und militärischen Schutzbauten oder sonstigen schutzbedürftigen Einrichtungen.
Bislang ist kein umfassender Schutz bekannt im Bereich der beispielhaft geschilderten Gebäude, Gebäudeteile und Gebäudetrennelemente und deren Verglasung gegen:
- Beeinflussung durch äußere Störquellen
- Beeinflussung durch äußere Störimpulse
- Beeinflussung durch gebäudeinnere Störquellen und -impulse
- Abhörsicherheit gegen die Industriespionage
- Schutz gegen elektronische Störbeeinflussung.

Aufgabe der Erfindung ist es demnach, ein Schutz-Fensterelement obengenannter Gattung anzugeben, das einen optimalen Schutz gegen die vorgenannten inneren und äußeren Störquellen bzw. -einflüsse oder -eingriffe in konstruktiv einfacher Weise sicherstellt.

Diese Aufgabe wird durch ein Schutz-Fensterelement obengenannter Gattung mit den Merkmalen des Anspruch 1 gelöst. Weitere vorteilhafte Ausgestaltungen sind in den Unteransprüchen gekennzeichnet.

Demgemäß ist die metallische Zwischenschicht eine über die gesamte Flächenausdehnung des Glaspakets sich erstreckende Metallschicht, die in leitendem Kontakt steht mit einem vorzugsweise außerhalb des Glas-Schirmpakets befindlichen Kontaktelement. Hierdurch wird ein Schutzschild geschaffen, durch welches äußere, in den abzuschirmenden Raum eindringende Störeinflüsse optimal abgeblockt werden können.

Alternativ kann das Kontaktelement auch bündig mit dem Glas-Schirmpaket oder leicht zurückversetzt in einer Vertiefung angeordnet sein, sofern entsprechend komplementäre Rahmenprofile oder leitende Zwischenelemente zur Verfügung stehen.

Der so gebildete, elektrisch leitende bzw. ableitende Schutzschirm kann erfindungsgemäß eine transparente, an sich bekannte metallische Beschichtung sein, die aus einer oder mehreren, übereinander aufgebrachten Schichten besteht und auf mindestens einer der Glasflächen des Verbundglaspakets aufgebracht ist.

Vorzugsweise ist die Metallbeschichtung auf der Innenscheibe des Verbundpakets aufzubringen, wodurch sie gleichzeitig geschützt ist, insbesondere gegen mechanische Zerstörung. Gemäß einer Weiterbildung des Erfindungsgedankens kann die Metallschicht auch eine selbständige, mit den Glasscheiben des Verbundpakets nicht in Kontakt stehende Einlage sein, wobei diese vorzugsweise als metallisches Gewebe ausgebildet sein kann. Dabei kann bei einem mehrscheibigen Verbundpaket nur eine Gewebegitter-Einlage vorgesehen sein, die vorzugsweise möglichst innenliegend anzuordnen ist. Zur Erhöhung des Abschirmeffekts kann jedoch auch in allen Glasscheibenzwischenräumen des aus mehreren Glasscheiben zusammengesetzten Verbundpakets je eine Gewebegitter-Einlage angeordnet sein.

Die Gewebegitter-Einlagen können aus Drahtgeweben mit unterschiedlicher Maschenweite und/oder unterschiedlichem Drahtdurchmesser gebildet sein. So können beispielsweise bei einem aus mehreren Glasscheiben und entsprechend vielen Gewebegitter-Einlagen zwischen diesen, die Einlagen entweder aus identischen Gewebegittern oder aus Gewebegittern mit unterschiedlicher Maschenweite und Drahtdurchmesser zusammengesetzt sein. Durch die Verwendung mehrerer unterschiedlicher Gewebegitter-Einlagen kann ein höherer Abschirmungseffekt erzielt werden, da eine höhere Störbandbreite erfaßt werden kann.

Des weiteren kann es von Vorteil sein, wenn die Gitterflächen einer farblichen Behandlung unterzogen werden, wodurch eine erhöhte Transparenz erzielt wird.

Ferner wirkt es sich vorteilhaft aus, wenn der Abstand zwischen den einzelnen Metallgewebegitter-Einlagen untereinander unterschiedlich ist. Dies in Kombination mit der unterschiedlichen Ausführung der einzelnen Gewebegitter-Einlagen in bezug auf Maschenweite und Drahtdurchmesser, bringt eine weitere Abschirmeffekterhöhung.

Eine besonders gute Ableitungswirkung wird erzielt, wenn die aus dem Plattenverbund herausragenden Kontaktelemente der Beschichtungen oder Gewebegitter-Einlagen als gleichmäßig um das Verbundpaket umlaufende Kontaktprofilfahnen ausgebildet sind, wodurch praktisch ein Kontaktrahmen entsteht.

Die rahmenförmigen Kontaktierungsfahnen können in vorteilhafter Weise mit einer Kontaktierungsprofilleiste verbunden sein, die eine großflächige Ableitungskontaktierung aufweist und damit die Ableitung zwischen Kontaktfahnen und Metallrahmen optimiert.

In Weiterbildung das Erfindungsgedankens kann die leitende Einlage als eine sogenannte Aktivantenne ausgebildet sein. Diese Ausführungsform wird insbesondere zur Ausstrahlung von definierten Störstrahlungen nach außen eingesetzt. Dabei ist diese Aktivantenne entsprechend den notwendigen Sendefrequenzspektren ausgebildet, beispielsweise als profiliertes Drahtgewebe mit Streueffekt, wobei dieses beispielsweise aus Schleifendrähten zusammengesetzt sein kann.

Zur Erhöhung des Abschirmeffekts kann der Verbund mit Aktivantenne zusätzlich an seiner in bezug auf den abzuschirmenden Raum inneren Glasscheibe innenseitig, also zwischenraumseitig, eine Reflexions-Metallbeschichtung aufweisen. Bei dieser Ausführungsform sind die aus dem Glasplatten-Einlage-Verbundumfang herausragenden Anschluß/Kontaktelemente isoliert zur Kontaktierungsprofilleiste und zum Rahmenprofil geführt und stehen mit einer Einspeisungseinrichtung in Verbindung.

Von Vorteil wirkt sich des weiteren aus, wenn die zwischen den Glasplatten des jeweiligen Schirmpakets vorgesehene Gasfüllung aus einem Schirmungseigenschaften besitzenden Gas besteht, dessen Moleküle größer sind als die der Umgebungsluft. Es ist zu erkennen, daß durch die verschiedene Abschirmungseigenschaften aufweisenden Elemente wie Beschichtung, Gewebegitter- oder Antenneneinlage und Gasfüllung sehr gute Abschirmungseigenschaften erzielt werden können, insbesondere wenn diese, je nach notwendigem Einsatz, miteinander kombiniert werden. Je nachdem, wie diese einzelnen Elemente zueinander angeordnet werden, kann die Abschirmung weiter optimiert werden.

So ist sinnvoll, ein Abschirmpaket, bestehend aus einem Isolierglaspaket mit zwischengefülltem Gas und innerer leitender Mehrfachbeschichtung, an der Außenseite einer Fensterfläche als Vorsatz-Schirmpaket anzuordnen. Das Abhör-Schirmpaket mit der Aktivantenne und eventuell zusätzlicher Innen-Glasbeschichtung ist bzw. sind jeweils an einem Glas-Fensterelement innen vorzusetzen.

Eine besonders gute Abschirmung gegen praktisch alle Störeinflüsse wird erzielt, wenn als zentrales Fensterelement ein Schirmpaket mit mehreren Glasscheiben und entsprechend mehreren zwischenangeordneten Gewebegitter-Einlagen vorgesehen wird, auf das nach außen ein Paket mit innerer Mehrfachbeschichtung und nach innen ein Paket mit Aktivantenne aufgesetzt werden. Dabei wird die Wirkung noch zusätzlich erhöht, wenn zwischen den drei Schirmpaketen jeweils entsprechende Distanzzwischenräume vorgesehen werden. Durch Einfüllen zwischen allen Glasplatten von Abschirmungsgas wird eine optimale Voll-Abschirmungs-Kombination erzielt.

Die kombinierten Schirmpakete, beispielsweise ein aus drei abschirmungstechnisch unterschiedlich aufgebauten Schirmpaketen zusammengesetzte Dreifach-Schirmglaspaket ist mit einem gasdichten, leitenden Einfassungsprofil mit Durchdringungs- bzw. Überleitungseigenschaften an den dem Metallrahmen gegenüberstehenden Umfangsflächen eingefaßt. Aus diesen ragen dann lediglich die Kontaktierungsfahnen bzw. die Kontaktelemente/-Füße heraus. Dadurch wird ein kompakter, einteilig anmutender Gesamtzusammenbau geschaffen, der zudem als Ganzes leichter handhab- und einbaubar ist.

Eine weitere vorteilhafte Ausgestaltung der Erfindung wird erreicht, wenn zwei im wesentlichen gleich aufgebaute, getrennte Einzel-Schirmpakete zu einem Doppel-Schirmglaspaket zusammengesetzt werden (Lambda/2-Schirmfunktion). Eine spiegelsymmetrische Anordnung der beiden getrennten Einzel-Pakete wirkt sich besonders vorteilhaft aus.

Die Einzelglaspakete können im wesentlichen aus zwei Zueinander definiert beabstandeten Glasscheiben aufweisen, deren schmalseitig umlaufende Abstandsöffnung mit Glasleisten so verschlossen sind, daß ein Glashohlkörper entsteht. Dabei ist eine der großen Glasscheiben von allen vier Seiten her um einen bestimmten Wert kleiner als die ihr zugeordnete zweite Scheibe, so daß der Glashohlkörper eines jeden Einzelglaspakets die Form eines Pyramidenstumpfes besitzt. Der Winkel der Pyramidenmantelflächen zur großen Grundfläche bzw. hier zwischen den Schmalseiten-Glasscheiben und der großen Glasscheibe ist variabel wählbar, je nach Dämpfungsforderung über das Frequenzspektrum.

Die zwei Einzelglaspaket-Hohlkörper sind jeweils innenseitig, d.h. auf der gesamten Glas-Innenfläche mit einer leitenden Metallschicht versehen. Diese Schicht kann eine transparente Mehrfachbeschichtung oder ein Schirmdrahtgeflecht sein. Zudem können die Kontaktflächen durch Metall-Siebdruck hergestellt sein.

Bei dieser Ausführungsform findet die Kontaktierung zum Metall-Rahmenprofil über jeweils ein separates Übergangsleitungsprofil statt, das im jeweiligen Einzelpaket formmäßig integriert ist. So kann das Profil im Quersachnitt die Form eines rechtwinkligen Dreiecks aufweisen, die genau auf die umlaufende Abschrägung des Einzelglaspakets abgestimmt ist. Bei Zusamensetzung eines Einzelpakets mit einem Übergangsleitungsprofil wird insgesamt eine einfache Kastenform erhalten, die durch ein einfaches Einfassungsprofil zusammengehalten werden kann. Dadurch wird in zusammengesetzter Form ein kompaktes, in der Außenform einfaches und in bezug auf die Metall-Rahmenprofile gut einbettbares Doppel-Schirmpaket geschaffen.

Um einen Lambda/2-Effekt zu erhalten ist von Vorteil, wenn die beiden Einzelglaspakete so zu einem Doppel-Schirmpaket zusammengesetzt werden, daß sie inbezug auf Ihre Pyramidenstumpf-Form sich jeweils mit der kleineren Glasscheibe gegenüberliegen. Hierdurch wird ein verengter Durchlaß in der Doppel-Schirmpaket-Mitte erreicht, der durch die Beschichtung der winklig einwärts gezogenen Umrandungsflächen gleichzeitig eine reflektierende Wirkung hat. Selbstverständlich kann auch eine spiegelbildliche Zuordnung der Einzelglaspakete in umgekehrter Weise erfolgen, also so, daß sie sich mit ihren großen Glasscheiben gegenüberstehen.

Von Vorteil ist des weiteren, wenn zwischen den beiden Einzelpaketen eine transparente, nichtleitende Zwischeneinlage vorgesehen ist, wodurch Störeinflüsse zwischen den beiden Einzelpaketen unterbunden werden.

Es wird ersichtlich, daß die erfindungsgemäßen Schutz-Fensterelemente in beliebiger Kombination der Schirmpakete sich besonders vorteilhaft in Verbindung mit Edelstahlfassaden verwenden lassen, wodurch entsprechend geschirmte Fassaden in optimaler, die guten Eigenschaften beibehaltende Fassaden geschaffen werden können. So können geschirmte Fassadenglaselemente, d. h. Fassaden-Bänder mit Varioanwendung von den Dämpfungseigenschaften her bereitgestellt werden. Es kann somit eine geschirmte Edelstahlfassade zusammengesetzt werden, bei der z. B. :
- im 2. OG, bei dem hinter der Fassade eine Entwicklungs- und Forschungsabteilung liegt, ein Schirmung gegen Industriespionage von z. B. 60 dB und mehr,
- im 9. OG, bei dem hinter der Fassade ein Besprechungszimmer der Gesschäftsleitung liegt, eine Schirmung gegen Anhören von z. B. 60 dB, und
- in anderen Geschoben keine Schirmung oder eine erforderlichenfalls geringere Schirmung von z. B. 40 dB, vorgesehen wird.

Nachfolgend wird die Erfindung anhand von mehreren Ausführungsbeispielen unter Bezug auf die Zeichnung näher erläutert.
- Fig. 1:: eine schematische Darstellung eines teilweisen Vertikal-Quersschnitts durch ein Schutz-Fensterelement in optimaler Dreifach-Kombination, als drei erfindungsgemäße Schirmpaket-Ausführungsformen zu einem Gesamtpaket zusammengeschlossen, und
- Fig. 2:: einen ähnlichen Schnitt wie in Fig. 1, eine weitere Ausführungsform der Erfindung als Doppel-Schirm-Glaspaket darstellend.

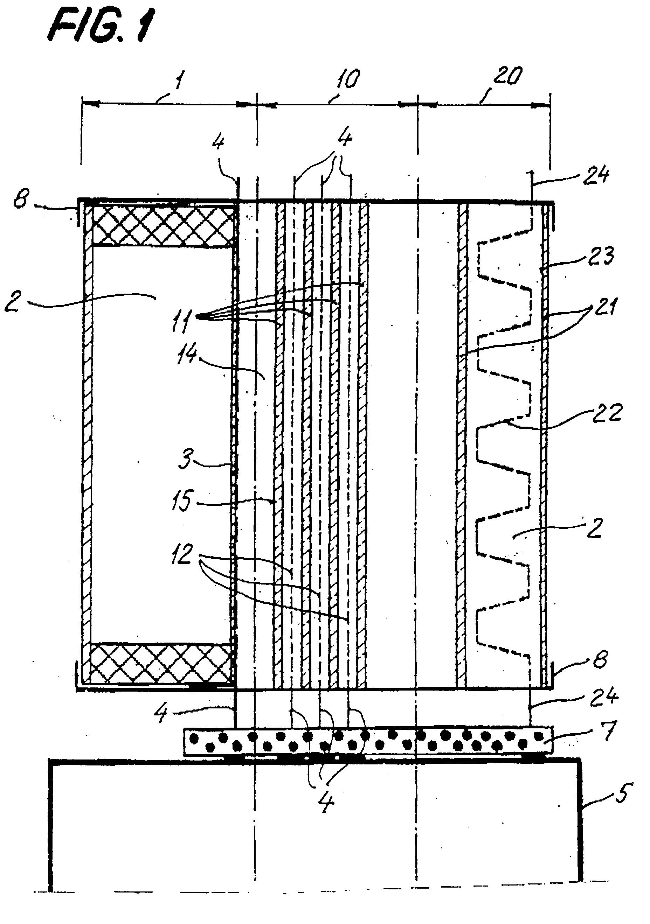

Das in Fig. 1 dargestellte Dreifach-Schirmglaspaket besteht erkennbar aus drei von außen nach innen in bezug auf einen abzuschirmenden Raum angeordnete Schirmpakete 1, 10 und 20.

Das im Verhältnis zum Innenraum an dritter Stelle, also außen angeordnete Schirmpaket 1 ist ein auch als selbständiges Vorsatz-Schirmpaket anbringbares Isolierglaspaket. Dieses besteht im wesentlichen aus zeichnerisch nicht speziell dargestellten mindestens zwei Glasscheiben, die in üblicher Weise auf Abstand zueinander und in bestimmter Auslegung angeordnet sind. Das Schirmpaket 1 ist so ausgelegt, daß, je nach Wahl der Einzelelemente und des Zwischenabstandes, eine ausreichende Schußsicherheit, Wärmedämmung, Schalldämmung oder andere positive physikalische Eigenschaften erzielt werden können.

Zwischen den mindestens zwei Glasscheiben des Schirmpakets 1 ist eine Gasfüllung 2 vorgesehen, die aus einem Schirmungseigenschaften besitzenden Gas, dessen Moleküle größer sind als die der Umgebungsluft, besteht.

Des weiteren ist an der inneren Glasscheibe des Schirmpakets 1 eine Beschichtung 3 mit metallischer, jedoch transparent verbleibender Oberfläche vorgesehen. Die Beschichtung 3 kann aus mehreren Auflageschichten bestehen, je nach schirmtechnischen Vorgaben der Permeabilität zur Erzielung der Dämpfungseigenschaften über ein Frequenzspektrum.

Ferner sind mit der Beschichtung 3 in Verbindung stehende, aus dem Außenumfang des Schirmpakets 1 herausragende, flächige Kontaktierungsfahnen 4 angeordnet, die um das Paket gleichmäßig ringsumlaufend vorgesehen sind. Sie dienen zur Kontaktierung der Beschichtung 3 mit einem an sich bekannten Metallrahmen-Profil 5.

Dem Metallrahmen-Profil 5 ist eine Kontaktierungsprofilleiste 7 zugeordnet, die mit den Kontaktierungsfahnen 4 und dem Profil 5 in leitendem Kontakt stehen. Die Leiste 7 besitzt leitende Eigenschaften zur Erreichung der notwendigen großflächigen Ableitungskontaktierung zwischen Beschichtung 3 und Profil 5. Das Kontaktierungsprofil 4 ermöglicht eine flächige Anpreßdruckkontaktierungsvergrößerung zu den umgebenden Metallrahmen-Profilen.

Das Dreifach-Schirmpaket 1, 10, 20 ist mit einem gasdichten, leitenden Einfassungsprofil 8 umgeben bzw. leicht umgreifend eingefaßt, wodurch praktisch ein einstückiges Kompaktpaket entsteht.

Das im Dreifachpaket nach Fig. 1 mittig angeordnete Schirmpaket 10 ist ein Verbundglasscheibensystem, das als Hoch- und Höchstschirmungsvariosystem sowohl aufgrund seiner Dämpfungseigenschaften als auch des sehr breiten Frequenzspektrums zur Schirmung verwendet werden kann, und zwar sowohl als Einzelpaket als auch in Kombination zum Vorsatz-Schirmpaket 1. Es kann jedoch auch als Einzelpaket zusätzlich zur Nachrüstung bestehender Fensterbänder verwendet werden.

Das Mittel-Schirmpaket 10 besteht aus mehreren, zu einem Verbund zusammengeschlossenen Glasscheiben 11, die in üblicher Weise zueinander beabstandet angeordnet sind. Zwischen diesen Glasscheiben 11 sind metallische Gewebegitter-Einlagen 12 von im wesentlichen gleicher Flächenerstreckung angeordnet. Diese Einlagen weisen Permeabilitätsvorgaben zur Verträglichkeit zum Kontaktierungsprofil 7 und den Rahmenprofilen 5 auf. Die Anzahl der Einlagen 12 richtet sich nach der Forderung der Schirmdämpfung und des Frequenzspektrums.

Die Metallgewebegitter-Einlagen 12 weisen bestimmte Eigenschaften auf, je nach Maschenweite und Drahtdurchmesser, die zur transparent-optischen Gestaltung, d.h. Durchsichtfähigkeit, wesentlich beitragen. Die Erhöhung der Transparenz der Einlagen wird zusätzlich durch farbliche Behandlung der Gitterflächen erzielt.

Der Abstand zwischen den Gewebegitter-Einlagen 12 ist variabel auslegbar. Dies kann durch die Glasscheiben 11, d.h insbesondere durch den Abstand zwischen diesen, ermöglicht werden. Besonders gute optische und schirmungstechnische Eigenschaften sind durch das Schirmpaket aus der Kombination der Auslegung der Glasscheiben 11 und der Gewebegitter-Einlagen 12 erzielbar (optische und schirmungstechnische Ablenkwinkel der beiden Größen).

Die Gewebegitter-Einlagen 12 sind in ähnlicher Weise wie die Beschichtung 3 mit je einer Kontaktierungsfahne 4 umgeben, die in gleicher Weise den Kontakt über die Kontaktierungsprofilleiste 7 mit dem Rahmenprofil 5 herstellen.

Bei Kombination des mittleren Schirmpakets 10 und des Vorsatz-Schirmpakets 1 wird ein schirmungstechnisch definierter Distanzzwischenraum 14 vorgesehen. Dieser dient zur nochmaligen steuerbaren Optimierung der Bautiefe des Kombinationssystems 1 + 10 (sog. "Wabenkamintiefenwellenabsorbtion"). Dabei spielt die absorbtionsfähige, optisch transparente Übernahmefläche 15 eine positive Rolle.

Das dritte Schirmpaket des Dreifachschirmglaspakets nach Fig. 1 ist das Innen-Schirmpaket 20. Es handelt sich bei diesem Schirmpaket 20 um ein autonomes Aktivgegensendepaket, das im wesentlichen aus einem transparenten Glaspaket besteht, das aus mindestens zwei Glasscheiben 21 zusammengesetzt ist, deren Zwischenräume wahlweise mit einer Schirm-Gasfüllung 2 versehen sein können. Zwischen zwei Glasscheiben 21 ist eine Aktivantenne 22 angeordnet. Durch diese wird eine Ausstrahlung von definierten Störstrahlungen nach außen (aktive Gegenstrahlung) vorgenommen.

Die Ausbildung der Aktivantenne 22 kann entsprechend den Prämissen des gewählten Sendefrequenzspektrums unterschiedlich vorgenommen werden. Hieraus ergibt sich auch die jeweilige Abstandstiefe zwischen den jeweils zwei, die Antenne einschließenden Glasscheiben 21. Die Aktivantenne kann dabei von Fall zu Fall, d.h. je nach Anwendung, aus profiliertem Drahtgewebe mit Streueffekt bis hin zu definierten Schleifendrähten bestehen.

Zur zusätzlichen Verhinderung massiver Störeinstrahlungen zum Innenraum ist die im Verhältnis zum Gebäudeinneren innenliegende Glasscheibe mit einer metallischen Reflexions-Beschichtung 23 versehen, die ähnlich ausgeführt ist wie die Beschichtung 3 des Schirmpakets 1.

Die aus dem Glaspaket des Schirmpakets 20 von der Antenne 22 herausgeführten Anschlußdrähte 24 sind isoliert zur Kontaktierungsprofilleiste 7 und zum Metall-Rahmenprofil 5 ausgelegt bzw. geführt, und zwar zu einer in der Zeichnung nicht dargestellten Antenneneinspeisungseinrichtung.

Im Gegensatz der untereinander verkoppelbaren Schirmpakete 1 und 10 erfolgt die Integration des Schirmpakets 20 in das Gesamtsystem immer als in bezug auf den abzuschirmenden Raum erstes Schirmpaket.

Das Schirmpaket 20 ist primär anwendungsgerecht zur Verhinderung von Abhörangriffen und Datenmanipulationen auslegbar.

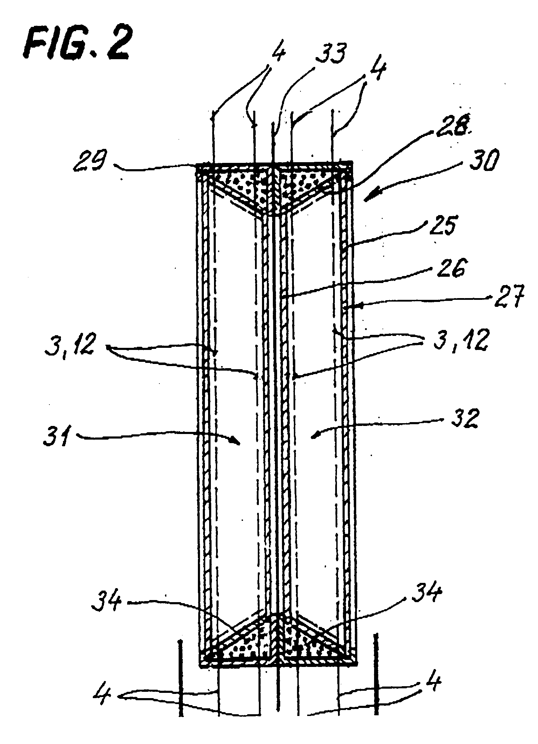

Fig. 2 zeigt ein erfindungsgemäßes Doppel-Schirmpaket 30, das aus zwei Einzel-Schirmpaketen 31 und 32 zusammengesetzt ist. Es ist leicht zu erkennen, daß die beiden Schirmpakete 31 und 32 spiegelsymmetrisch identisch ausgebildet sind. Der Grundgedanke dieser Anordnung besteht in einer Lambda/2-Schirmfunktion mit einer räumlich vergrößerten Schirmfläche und gleichzeitigen strikten Trennung der beiden Einzel-Schirmpakete 31 und 32.

Die Trennung bzw. Kontaktierungsverhinderung zwischen den beiden Schirmpaketen 31 und 32 erfolgt über eine zwischenangeordnete Isolier-Einlage 33, die transparent und gleichzeitig elektrisch nichtleitend ausgelegt ist. Als Einlage 33 ist z. B. eine transparente Isolierfolie geeignet.

Die Einzel-Schirmpakete 31 und 32 jeweils sind aus mehreren formangepaßten Teilen zusammengesetzt. So ist jeweils als zentrales Element ein Glashohlkörper 27 vorgesehen, der aus einer großen Glasscheibe 25, einer zu ersterer parallel und auf Abstand angeordneten kleineren Glasscheibe 26 und aus die Außenränder der beiden Glasscheiben verbindenden Glasleisten 28 so zusammengesetzt ist, daß er die Form eines Pyramidenstumpfes aufweist. Die so gebildeten Glashohlkörper 27 sind innen, d. h. an den Innenflächen der Glasscheiben 25, 26 und 28 entweder mit einer transparenten, metallischen Mehrfach-Beschichtung 3 oder mit einem Gewebegitter 12 bedeckt.

Wie aus Fig. 2 ersichtlich, ist in dem jeweiligen Einzel-Schirmpaket-Aufbau 31 bzw. 32, ein Übergangsleitprofil 34 formmäßig - hier in Form eines umlaufenden Dreiecks - so integriert, daß ein kompakter, jeweils rechteckiger Querschnitt zum leichten Einbau in die Rahmenprofile 5, erhalten wird. Dabei erfolgt die Kontaktierung der Beschichtung 3 oder des Gewebegitters 12 über das Übergangsleitprofil 34 fortführend bis zum Rahmen 5 ebenfalls getrennt pro Einzel-Schirmpaket 31 und 32 über entsprechende Kontaktfahnen 4.

Die Einzel-Schirmpakete 31 sind jeweils mit einem Einfassungsprofil 29 umgeben, das den Außenrand der Pakete 31, 32 formmäßig einfach und kompakt abschließen.

Aus Fig. 2 wird auch ersichtlich, daß die Glasscheiben 25 und 26 auch gleich ausgebildet sein können, d. h. gleiche Längen- und Höhenabmessungen aufweisen können. Wichtig dabei ist, daß die Glasleisten 28 so bemessen und zwischen die beiden Scheiben 25 und 26 eingesetzt werden, daß ihre Neigung zu diesen dem vorgesehenen Schirmungswinkel entspricht und sie eine gute Formeinfügung des Übergangsleitprofils 34 erlauben.

Analog zur Ganzflächen-Metallbeschichtung 3 oder zum Gewebegitter 12 kann eine Abschirmung durch Metallaufbringung mit Hilfe der Technik des Siebdrucks erfolgen.

Insgesamt ist zu bemerken, daß die Doppel-Schirmpaket-Konstruktion 30 eine erheblich vergrößerte Schirmflächenauflage aufweist. Sie ist kompatibel mit den Schirmpaketen 1 und 10 gemäß Fig. 1, kann jedoch je nach Dämpfungsgrad und im Verhältnis zum Frequenzspektrum der Abschirmung auch selbständig eingesetzt werden.

## Patentansprüche

1. Schutz-Fensterelemente, insbesondere für Gebäudeinnen- oder -außenwandelemente, mit
- einem Fensterrahmen, insbes. einem Metallrahmen,
- mindestens zwei zu einem Verbundpaket zusammengefaßten, zueinander jeweils mit Zwischenraum beabstandeten, parallelen Glasscheiben,
- einer transparenten, metallischen Zwischenschicht
- und einer in den Glas-Zwischenraum eingebrachten Gasfüllung
**dadurch gekennzeichnet**,
daß die metallische Zwischenschicht mindestens eine über die gesamte Flächenausdehnung des Glaspakets sich erstreckende Metallschicht (3, 12) ist, die mit am Außenrand des Glaspakets vorgesehenen, insbesondere über den Aussenrand herausragenden Kontaktierungselementen (4, 24) leitend verbunden ist.

2. Schutz-Fensterelemente nach Anspruch 1,
dadurch gekennzeichnet, daß die Metallschicht eine Metall-Beschichtung (3) ist, die auf mindestens einer der Flächen mindestens einer der Glasscheiben aufgebracht ist.

3. Schutz-Fensterelemente nach Anspruch 2,
dadurch gekennzeichnet, daß die Beschichtung (3) auf der in bezug auf den abzuschirmenden Raum auf der inneren Glasscheibe vorgesehen ist.

4. Schutz-Fensterelemente nach Anspruch 1,
dadurch gekennzeichnet, daß die aus den Verbundglas-Element herausragenden Kontaktierungselemente Kontaktprofilfahnen (4) sind.

5. Schutz-Fensterelemente nach Anspruch 4,
dadurch gekennzeichnet, daß die Kontaktprofilfahnen (4) mit den Rahmenprofilen (5) in Ableitungskontakt stehen.

6. Schutz-Fensterelemente nach Anspruch 5,
dadurch gekennzeichnet, daß die Kontaktprofilfahnen (4) umlaufend um das gesamte Glaspaket angeordnet sind.

7. Schutz-Fensterelemente nach Anspruch 6,
dadurch gekennzeichnet, daß das Verbund-Glaspaket (1, 10, 20) an seinem gesamten äußeren Rand mit einem gasdichten, leitenden Einfassungsprofil (8, 29) umgeben ist.

8. Schutz-Fensterelemente nach den Ansprüchen 1 und 3,
dadurch gekennzeichnet, daß zwischen Glaspaket und Metallrahmen (5) eine Kontaktierungsprofilleiste (7, 34) vorgesehen ist, die einen flächigen Kontakt zwischen Kontaktfahne (4) und Rahmen (5) und/oder Beschichtung (3) herstellt.

9. Schutz-Fensterelemente nach Anspruch 1,
dadurch gekennzeichnet, daß die Metallschicht eine metallische Gewebegitter-Einlage (12) ist.

10. Schutz-Fensterelemente nach Anspruch 9,
dadurch gekennzeichnet, daß die Gewebegitter-Einlage (12) jeweils zwischen zwei Glasscheiben (11, 12) eines Verbundpaketes (10, 20) angeordnet ist.

11. Schutz-Fensterelemente nach den Ansprüchen 9 und 10,
dadurch gekennzeichnet, daß bei Anordnung mehrerer Glasscheiben (11) in einem Paket (10) in einem oder mehreren der Zwischenräume jeweils eine oder mehrere Gewebegitter-Einlagen (12) angeordnet sind.

12. Schutz-Fensterelemente nach den Ansprüchen 9 bis 11,
dadurch gekennzeichnet, daß bei Verwendung mehrerer Gewebegitter-Einlagen (12) in einem Verbundpaket (10) identisch ausgebildete oder in bezug auf Maschenweite und Drahtdurchmesser unterschiedliche Gewebegitter verwendet werden.

13. Schutz-Fensterelemente nach Anspruch 19,
dadurch gekennzeichnet, daß zur Erhöhung der Transparenz eine farbliche Behandlung der Gewebegitterflächen vorgenommen wird.

14. Schutz-Fensterelemente nach einem der Ansprüche 9 bis 13,
dadurch gekennzeichnet, daß der Abstand der Gewebegitter-Einlagen (12) zueinander unterschiedlich ist.

15. Schutz-Fensterelemente nach Anspruch 1,
dadurch gekennzeichnet, daß die Moleküle des zwischen den Glasscheiben des Verbundpakets eingefüllten Gases (2) größer sind als die der Umgebungsluft.

16. Schutz-Fensterelement nach Anspruch 1 oder 9,
dadurch gekennzeichnet, daß zwischen den zwei Glasscheiben (21) eines Verbundpakets (20) eine metallische Aktivantenne (22) angeordnet ist (zur Ausstrahlung von definierten Störstrahlungen nach außen).

17. Schutz-Fensterelemente nach Anspruch 16,
dadurch gekennzeichnet, daß die Aktivantenne (22) je nach notwendigen Sendefrequenzspektren unterschiedlich ausgebildet ist.

18. Schutz-Fensterelement nach Anspruch 17,
dadurch gekennzeichnet, daß die Aktivantenne (22) ein profiliertes Drahtgewebe mit Streueffekt ist.

19. Schutz-Fensterelement nach Anspruch 18,
dadurch gekennzeichnet, daß das profilierte Drahtgewebe aus Schleifendrähten besteht.

20. Schutz-Fensterelemente nach Anspruch 15,
dadurch gekennzeichnet, daß zusätzlich zu der zwischen zwei Glasscheiben angeordneten Aktivantenne (22) die in bezug auf den abzuschirmenden Raum innere Glasscheibe (21) eine Reflexions-Metallbeschichtung (23) aufweist.

21. Schutz-Fensterelemente nach einem der Ansprüche 16 bis 20, dadurch gekennzeichnet, daß die aus dem Glasverbund-Umfang herausragenden Anschlußdrähte (24) der Aktivantenne (22) (und der Reflexionsmetallbeschichtung) isoliert zur Kontaktierungsleiste (7) und zum Rahmenprofil (5) geführt sind und in Verbindung stehen mit einer Antenneneinspeiseeinrichtung.

22. Schutz-Fensterelemente nach einem der Ansprüche 15 bis 21, dadurch gekennzeichnet, daß die Anordnung des Verbundpakets (20) mit Aktivantenne (22) immer in bezug auf den abzuschirmenden Raum als innenliegendes Zusatzpaket erfolgt.

23. Schutz-Fensterelemente nach Anspruch 1,
dadurch gekennzeichnet, daß ein aus zwei getrennten, vorzugsweise in spiegelsymmetrischer Ausführungsform ausgebildeten Einzelschirmpaketen (31, 32) zusammengesetztes Doppelschirmpaket (30) vorgesehen ist (Lambda/2-Schirmfunktion).

24. Schutz-Fensterelemente nach Anspruch 23,
dadurch gekennzeichnet, daß zwischen den beiden Einzel-Schirmpaketen (31, 32) eine transparente, nichtleitende Zwischeneinlage (33) vorgesehen ist.

25. Schutz-Fensterrahmen nach einem der Ansprüche 23 und 24,
dadurch gekennzeichnet, daß die beiden Einzel-Schirmpakete (31, 32) je einen Glas-Hohlkörper (27) aufweisen, der die Form eines Pyramidenstumpfes aufweisen und daß die Innenflachen des Hohlkörpers (27) mit einer transparenten elektrisch leitenden Beschichtung versehen sind, die als Mehrfach-Beschichtung (3) oder als Gewebegitter (12) ausgebildet sein kann.

26. Schutz-Fensterrahmen nach Anspruch 25,
dadurch gekennzeichnet, daß die pyramidenstumpfförmigen Glaskörper (27) so spiegelsymmetrisch zueinander angeordnet sind, daß jeweils die kleinen Grundflächen, also die kleinen Glasscheiben (26) benachbart liegen, eine mittige Durchlaßverrigerung bildend.

27. Schutz-Fensterelemente nach Anspruch 25,
dadurch gekennzeichnet, daß die Beschichtung als Metallsiebdruck-Kontaktflächen gefertigt sind.

28. Schutz-Fensterelemente nach einem der Ansprüche 23 bis 26, dadurch gekennzeichnet, daß die Kontaktierung der leitenden Schichten (3, 12) zum Rahmenprofil (5) jeweils über ein separates Übergangsleitprofil (34) vorgesehen ist, das in dem Schirmpaket-Aufbau (30) integriert ist und daß die mit dem Rahmenprofil (5) in Verbindung stehenden Kontaktierungsfahnen (4) durch das Übergangsleitprofil (34) hindurchgeführt sind und aus diesem herausragen.
